# EUROPEAN PATENT SPECIFICATION

(11) **EP 3 890 055 B1**
(45) Date of publication and mention of the grant of the patent: **07.06.2023**
(21) Application number: 20167146.8
(22) Date of filing: 31.03.2020
(51) Int. Cl.: G01R 31/36, H05K 1/18, H01M 10/48, H01M 10/42, G01R 31/382, H01M 50/204, H01M 50/249, H01M 50/502, H01M 50/284, G01R 31/396, H05K 1/02, H05K 3/32, H01M 50/569, H01M 50/543

(54) **BATTERY SYSTEM WITH A FLEXIBLE PRINTED CIRCUIT COMPRISING A PLURALITY OF INTEGRATED CIRCUITS FOR VOLTAGE AND TEMPERATURE MEASUREMENT**
BATTERIESYSTEM MIT EINER FLEXIBLEN LEITERPLATTE MIT MEHREREN INTEGRIERTEN SCHALTUNGEN ZUR SPANNUNGS- UND TEMPERATURMESSUNG
SYSTÈME DE BATTERIE AYANT UN CIRCUIT IMPRIMÉ FLEXIBLE COMPRENANT UNE PLURALITÉ DE CIRCUITS INTÉGRÉS POUR LA MESURE DE LA TENSION ET DE LA TEMPÉRATURE

(43) Date of publication of application: 06.10.2021
(73) Proprietor: Samsung SDI Co., Ltd., Gyeonggi-do 17084 (KR)
(72) Inventor: Erhart, Michael, 8054 Seiersberg-Pirka (AT); Reinprecht, Wolfgang, 8144 Attendorf (AT)
(74) Representative: Gulde & Partner

(56) References cited:
- WO-A1-2010/074290
- WO-A1-2012/011237
- DE-A1-102011 016 373

## Description

### Field of the Invention

The present invention relates to a battery system for battery electric vehicles with a flexible printed circuit as an essential part of the battery system, and a battery electric vehicle including the battery system.

### Technological Background

In the recent years, vehicles for transportation of goods and people have been developed using electric power as a source for motion. Such an electric vehicle is an automobile that is propelled by an electric motor, using energy stored in rechargeable batteries. An electric vehicle may be solely powered by batteries or may be a form of hybrid vehicle powered by for example a gasoline generator. Furthermore, the vehicle may include a combination of electric motor and conventional combustion engine. In general, an electric-vehicle battery (EVB) or traction battery is a battery used to power the propulsion of battery electric vehicles (BEVs). Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose. Lithium-ion (and similar lithium polymer) batteries, widely known via their use in laptops and consumer electronics, dominate the most recent group of electric vehicles in development.

Rechargeable batteries may be used as a battery module formed of a plurality of unit battery cells coupled in series and/or in parallel so as to provide a high energy density, in particular for motor driving of a hybrid vehicle. That is, the battery module is formed by interconnecting the electrode terminals of the plurality of unit battery cells depending on a required amount of power and in order to realize a high-power rechargeable battery.

Also the battery modules may be configured in a series, parallel or a mixture of both to deliver the desired voltage, capacity, or power density. Components of battery packs include the individual battery modules, and the interconnectors, which provide electrical conductivity between them.

The mechanical integration of such a battery system requires appropriate mechanical connections between the individual components, e.g. of battery modules, and between them and a supporting structure of the vehicle. These connections must remain functional and save during the average service life of the battery system. Further, installation space and interchangeability requirements must be met, especially in mobile applications.

Mechanical integration of battery modules may be achieved by providing a carrier framework and by positioning the battery modules thereon. Fixing the battery cells or battery modules may be achieved by fitted depressions in the framework or by mechanical interconnectors such as bolts or screws. Alternatively, the battery modules are confined by fastening side plates to lateral sides of the carrier framework. Further, cover plates may be fixed atop and below the battery modules.

To provide thermal control of the battery system a thermal management system is required to safely use the at least one battery module by efficiently emitting, discharging and/or dissipating heat generated from its rechargeable batteries. If the heat emission/discharge/dissipation is not sufficiently performed, temperature deviations occur between respective battery cells, such that the at least one battery module cannot generate a desired amount of power. In addition, an increase of the internal temperature can lead to abnormal reactions occurring therein and thus charging and discharging performance of the rechargeable deteriorates and the life-span of the rechargeable battery is shortened. Thus, cell cooling for effectively emitting/discharging/dissipating heat from the cells is required.

Accordingly, a measurement of cell temperature and voltage is necessary to keep a check on the status of the battery system, as safety related issues can occur. Integrated circuits ICs are used for cell voltage measurement and are designed to handle 6 to 12 battery cells with one chip of the respective IC. Technologies involving one chip for one battery cell are being used since such chips have advantages in terms of modularity, cell temperature measurement and accuracy. Furthermore, the one chip for one cell technology allows extra measurement functionalities and the usage of cheaper chip processes. However, the chips of the respective IC need to be soldered on a printed circuit board PCB and connected to the corresponding battery cells of the battery system. Furthermore, the communication lines have to be routed through the PCB with additional wiring harnesses, which would significantly increase the overall costs. Moreover, the aforementioned technologies need packaged parts and a soldering process, which leads to a higher overall cost. Hence, a smart solution is needed, especially for the assembly process, so as to provide additional benefits as well as to reduce the overall costs.

WO 2010/074290 A1 discloses a battery monitoring device composed of a battery package including battery units and integrated circuits provided for each battery units and a control unit, wherein each IC is configured to measure voltage and temperature of the battery units and send the voltages and temperatures to the control unit.

DE 10 2011 016 373 A1 discloses a battery module including a voltage balancing circuit being in contact with the terminals of the single batteries by means of a flexible printed circuit FPC.

WO 2012/011237 A1 discloses a battery block including a plurality of battery cells. An FPC substrate is provided to one surface of the battery block. A circuit for detecting voltage between terminals of each battery cell of the battery block is mounted on the FPC substrate.

It is thus an object of the present invention to overcome or reduce at least some of the drawbacks of the prior art and to provide a battery system that can enable voltage and temperature measurement in an efficient and cost effective manner.

### Summary of Invention

Embodiments of the present disclosure seek to solve at least one of the problems existing in the prior art to at least some extent.

According to one aspect of the present disclosure, a battery system for battery electric vehicles is provided. The battery system comprises a plurality of battery units, wherein each battery unit comprises at least one battery cell, each battery cell including a positive terminal, a negative terminal and a cell case. The battery system further comprises a flexible printed circuit, FPC, comprising a plurality of integrated circuits, ICs, configured for voltage measurement and temperature measurement. The ICs are interconnected by a wiring structure of the FPC, wherein each IC is thermally connected to a cell case of one of the battery cells of each battery unit via a contact element being disposed in the FPC and said IC is further electrically connected via the contact element to the respective positive terminal of the one battery cell.

The IC may comprise a die with interface bumps on a side of the die facing the FPC, wherein the die may be connected to the FPC via the interface bumps.

The die may be integrated to the FPC by means of a connecting material between the chip-die and the FPC.

A number of ICs of the FPC may correspond to a number of battery units such that one IC corresponds to one battery unit.

The contact element may comprise at least one welded contact between the FPC and the cell case of the one battery cell of the corresponding battery unit.

A case cover of the cell case of the one battery cell of the corresponding battery unit may be electrically connected to the positive terminal of the one battery cell and may be electrically isolated from the negative terminal of the one battery cell.

The negative terminal of the one battery cell may be electrically connected to a positive terminal of the one battery cell of an adjacent battery unit via a busbar.

The IC may be configured to detect a voltage drop caused by a resistance of the busbar.

A communication between the ICs may be realized by a daisy-chain communication.

A positive terminal of the IC may be connected to the cell case of the one battery cell of the corresponding battery unit and negative terminal of said IC is electrically connected the cell case of the one battery cell of a neighboring battery unit, which may have a lower voltage than that of the corresponding battery unit.

Each IC may comprise two first bidirectional communication ports connected to the one battery cell of a first neighboring battery unit and two second bidirectional communication ports connected to the one battery cell of a second neighboring battery unit.

The FPC may be adapted as a tape on reel with a predefined pitch of the ICs depending on the width of the battery cells.

The battery system may comprise a battery management system BMS, wherein at least one end of the FPC is electrically connected to the BMS.

According to another aspect of the present disclosure, a battery electric vehicle including a battery system as defined above is provided.

Further aspects of the present invention could be learned from the dependent claims or the following description.

### Brief Description of the Drawings

Features will become apparent to those of ordinary skill in the art by describing in detail exemplary embodiments with reference to the attached drawings in which:
Fig. 1 illustrates a top view on a part of a battery system according to a first embodiment with a serial connection of battery units and a flexible printed circuit, FPC, including integrated circuits, ICs, being modified for measurement of voltage and temperature of single battery units.
Fig. 2 schematically illustrates a part of the FPC useable for implementing the battery system of Fig. 1.
Fig. 3 illustrates a perspective view onto a bottom side of an exemplary IC, which may be integrated into the FPC.
Fig. 4 shows an enlarged side view onto the FPC in a section with the IC of Fig. 3.
Fig. 5 schematically illustrates the bonding of the FPC of Fig. 4 onto a battery unit.
Fig. 6 illustrates a top view onto a battery system with a flexible printed circuit according to another embodiment.
Fig. 7 illustrates a top view on a part of a battery system according to a second embodiment with a serial connection of battery units including subunits of battery cells being connected in parallel and an FPC for measurement of voltage and temperature of single battery units.

### Detailed Description of the Invention

Features of the inventive concept and methods of accomplishing the same may be understood more readily by reference to the following detailed description of embodiments and the accompanying drawings. Unless otherwise noted, like reference numerals denote like elements throughout the attached drawings, and thus, descriptions thereof may not be repeated. In the drawings, the relative sizes of elements, layers, and regions may be exaggerated for clarity. As used herein, the term "and/or" includes any and all combinations of one or more of the associated listed items.

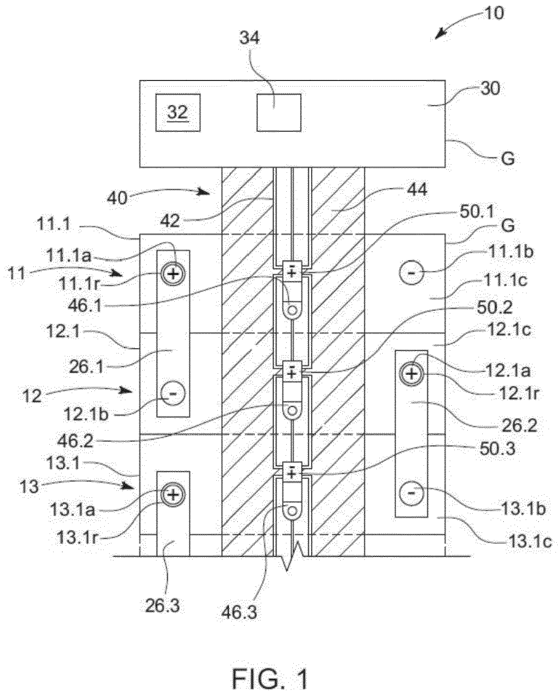

Fig. 1 illustrates a top view on a part of a battery system 10 according to a first embodiment of the present disclosure. The battery system 10 comprises a plurality of battery units, for example, a first battery unit 11, a second battery unit 12 and a third battery unit 13. According to the embodiment illustrated in Fig. 1, each of the battery units 11, 12, and 13 comprises one single battery cell 11.1, 12.1, and 13.1, respectively.

Each of the plurality of battery cells 11.1, 12.1 and 13.1 includes an electrode assembly comprising a positive electrode, a negative electrode, and a separator interposed between the positive and negative electrodes, a case receiving the electrode assembly, and electrode terminals electrically connected to the electrode assembly. In detail, each of the plurality of battery cells 11.1, 12.1 and 13.1 includes a respective positive terminal 11.1a, 12.1a, 13.1a, and a respective negative terminal 11.1b, 12.1b, 13.1b. That is, the first battery cell 11.1 includes the first positive terminal 11.1a and the first negative terminal 11.1b. The second battery cell 12.1 includes the second positive terminal 12.1a and the second negative terminal 12.1b. The third battery cell 13.1 includes the third positive terminal 13.1a and the third negative terminal 13.1b. According to the exemplary embodiment illustrated in Fig. 1, the battery cells 11.1, 12.1, and 13.1 are connected in series via busbars 26.1, 26.2, and 26.3.

The cell cases of the battery cells 11.1, 12.1, 13.1 are composed of a case body and a case cover 11.1c, 12.1c and 13.1c, respectively. The electrode assemblies of the battery cells 11.1, 12.1, 13.1 may be formed as a jelly roll type electrode assembly by spirally winding a positive electrode connected with the positive terminal 11.1a, 12.1a and 13.1a and a negative electrode connected with the negative terminal 11.1b, 12.1b and 13.1b with a separator therebetween (not shown in figures). The electrolyte may include a lithium salt, such as LiPF₆ or LiBF₄ and an organic solvent, such as EC, PC, DEC, EMC, or EMC. The electrolyte solution may be in a liquid, solid, or gel state. The case cover 11.1c, 12.1c and 13.1c hermetically seals an opening of the case body.

The battery cell 11.1, 12.1, 13.1 is described as a non-limiting example of a lithium secondary battery configured to have a prismatic (or rectangular) shape. The case body may be configured to have a substantially cuboidal shape, and an opening may be formed at one side thereof, which is closed by the case cover 11.1c, 12.1c, 13.1c. The case body as well as the case cover 11.1c, 12.1c, 13.1c may be formed of a metal, such as aluminum.

The battery system 10 generally comprises a cooling system, for example based on a cooling liquid, wherein the cooling system is configured to provide the cooling liquid for cooling the respective battery cells 11.1, 12.1 and 13.1 (not shown in the figures). The cooling liquid may absorb heat generated by the battery cells 11.1, 12.1 and 13.1 during the operation of the battery system 10.

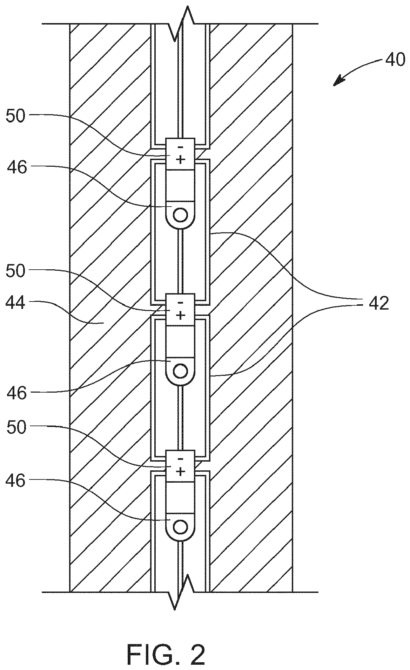

The battery system 10 further comprises a flexible printed circuit FPC 40. An exemplary section of the FPC 40 according to an embodiment is shown in detail in Fig. 2. The FPC 40 consists of a metallic traces 42, usually copper, bonded to a dielectric layer 44, such as polyimide. Because copper tends to readily oxidize, the exposed surfaces are often covered with a protective layer, gold or solder are the two most common materials because of their conductivity and environmental durability. For non-contact areas a dielectric material is used to protect the metallic traces 42 from oxidation or electrical shorting. The FPC 40 may be a single sided circuit. Single sided circuits consist of a single layer of metal traces 42 on one side of the dielectric layer 44. The metal traces 42 of the FPC 40 form a wiring structure specific to consumer's design requirements. Fig. 2 illustrates metal traces 42 of the wiring structure, which are required for the measurement of temperature and voltage of the battery units 11, 12, 13. The wiring structure may include further metallic traces providing additional functions.

The FPC 40 further comprises a plurality of integrated circuits ICs 50 configured for voltage measurement and temperature measurement, wherein the ICs 50 being interconnected by the wiring structure of the FPC 40. Furthermore, the FPC 40 includes a plurality of contact elements 46. The number of contact elements 46 is equal to the number of ICs 50 and contact elements and ICs 50 are assembled pairwise and closed to each other. The function of the contact elements 46 is explained in more detail below.

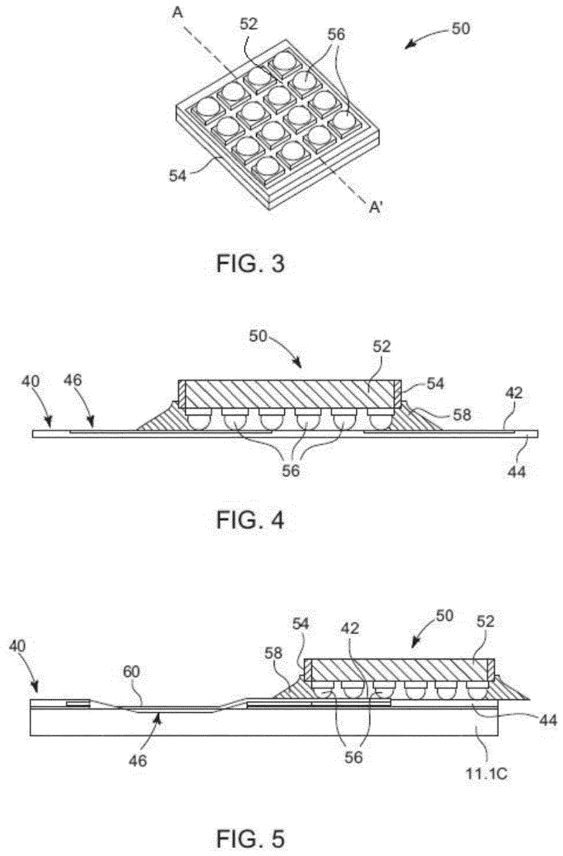

Fig. 3 depicts a perspective view onto a bottom side of an exemplary IC 50, which may be integrated into the FPC 40. Here, the IC 50 includes a die 52 integrated into a die carrier 54.

The IC 50 further includes a number of interface bumps 56 for establishing electric or thermal connection to the die 52. The interface bumps 56 are provided on a bottom side of the die 52 and face the FPC 40. The shape, size and pattern of the interface bumps 56 is not limited to that depicted in embodiment shown in Fig. 3, e.g. as a hemi-sphere, as desired shape. The size, number and pattern of the interface bumps 56 can be identified and chosen by a person skilled in the art based on the specific requirements of the embodiment.

The IC 50 includes means for detecting a temperature. For example, the IC 50 may include a negative temperature coefficient (NTC) thermistor. A thermistor is a thermally sensitive resistor that exhibits a large, predictable, and precise change in resistance correlated to variations in temperature. An NTC thermistor provides a very high resistance at low temperatures. As temperature increases, the resistance drops quickly. Because an NTC thermistor experiences such a large change in resistance per °C, small changes in temperature are reflected very fast and with high accuracy (0.05 to 1.5 °C). Because of its exponential nature, the output of an NTC thermistor requires linearization. The effective operating range is -50 to 250 °C. In alternative, a semiconductor-based temperature sensor is placed on IC 50. These sensors are effectively two identical diodes with temperature-sensitive voltage vs current characteristics that can be used to monitor changes in temperature.

Fig. 4 shows a cross-sectional view on the arrangement of the IC 50 and the FPC 40, wherein the cross-sectional view in the area of IC 50 runs through the axis A-A' shown in Fig. 3. As schematically illustrated in the exemplary embodiment, the die 52 is electrically connected directly to the wiring structure of the FPC 40 via the interface bumps 56. Therefore, the IC 50 is placed onto the side of the FPC 40 bearing the wiring structure such that single interface bumps 56 or groups of interface bumps 56 are in electrically connected with selected metal traces 42 of the FPC 40. Specifically, a number of the interface bumps 56 are electrically connected via a metal trace 42 with an area of the FPC 40 forming the contact element 46.

Furthermore, the IC 50 is bound to the FPC 40 by means of a connecting material 58. The connecting material 58 may be in form of an adhesive or a metallic filling material which could enable a fixation or integration of the IC 50 to the FPC 40. The connecting material 58 enables a reduction in mechanical stress to the die 52. Furthermore, the mechanical stress is also reduced due to the flexible structure of the FPC 40. It is to be noted that, materials which could be used as under filling materials which could be known to a person skilled in the art may be also used as the connecting material 58.

Coming back to Fig. 1, the number of ICs corresponds to the number of battery units 11, 12 and 13, such that one IC 50.1, 50.2 and 50.3 corresponds to one battery unit 11, 12 and 13. That is, the first IC 50.1 corresponds to the first battery unit 11, the second IC 50.2 corresponds to the second battery unit 12 and the third IC 50.3 corresponds to the third battery unit 13. Thereby, the ICs 50.1, 50.2 and 50.3 enable the measurement of voltage and temperature of each battery unit 11, 12 and 13 of the battery system 10 with high accuracy.

In particular, each IC 50.1, 50.2 and 50.3 is thermally connected to a respective case cover 11.1c, 12.1c and 13.1c via the contact elements 46.1, 46.2, and 46.3 being disposed, for example being embedded, in the FPC 40. That is, the first IC 50.1 is thermally connected to the first case cover 11.1c via the first contact element 46.1, the second IC 50.2 is thermally connected to the second case cover 12.1c via the second contact element 46.2 and the third IC 50.3 is thermally connected to the third case cover 13.1c via the third contact element 46.3.

In order to enable a temperature measurement, the contact element 46.1, 46.2, and 46.3 comprises at least one welded contact 60 between the FPC 40 and the cell case 11.1c, 12.1c and 13.1c of the respective battery cells 11.1, 12.1 and 13.1. As shown in Fig. 1 and in particular Fig. 5, the first contact element 46.1 comprises a single welded contact 60, which is shown as a welded shape, whereby a metal trace 42 of the FPC 40 is electrically connected to the first case cover 11.1c. In other words, this enables a portion of the wiring structure of the FPC 40 corresponding to a region of the single welded contact 60, to come into direct thermal and electrical contact with the first case cover 11.1c. This in turn establishes a connection between the first IC 50.1 and the first case cover 11.1c via those interface bumps 56, which are in contact with the part of the wiring structure leading to the welded contact 60.

In other words, the first IC 50.1 will be able to measure the temperature of the first battery cell 11.1 via the connection between to the wiring structure of the FPC 40 and the first case cover 11.1c. Similarly, the second IC 50.2 and the third IC 50.3 will be able to measure the temperature of the second battery cell 12.1 of the second battery unit 12 and of the third battery cell 13.1 of the third battery unit 13, respectively. This is of advantage, because the connection of the ICs 50.1, 50.2 and 50.3 with the respective case covers 11.1c, 12.1c and 13.1c enables a more accurate measurement of the true temperature of the respective battery cells 11.1, 12.1 and 13.1. In conventional battery systems, the temperature is measured at the terminals or busbars interconnecting terminal of neighbored battery cells. However, these elements will heat up due when current flows through them. In other words, the metallic connection of the IC 50 to the wiring structure of the FPC 40 and further via the single welded contact 60 to the respective case covers 11.1c, 12.1c and 13.1c ensures a more accurate on-chip temperature measurement of the battery cells 11.1, 12.1, and 13.1. Furthermore, a row of cell cases provides a relatively flat surface compared to the protruding terminals 11.1a, 11.1b, 12.1a, 12.1b, 13.1a and 13.1b or the busbars 26.1, 26.2 and 26.3. Thus, it is easier to dispose the FPC 40 upon the case covers 11.1c, 12.1c and 13.1c.

A connection of multiple battery units 11, 12 and 13 within the battery system 10 can be established by an easy and reliable process just by the fact that only one single connection - that is the contact element 46 - of the FPC 40 to the related battery cell 11.1, 12.1, 13.1 of the respective battery unit 11, 12 and 13 is required. Furthermore, the FPC 40 comprising the plurality of ICs 50.1, 50.2 and 50.3 can be attached after the battery units 11, 12 and 13 (or modules comprising the battery units 11, 12 and 13) have been assembled to the battery system 10 (or a battery pack). Thus, the FPC 40 can be attached advantageously on a pack level rather than on a module level.

In the manufacturing process of the battery system 10, the FPC 40 is welded to the battery units 11, 12, and 13 at the contact elements 46.1, 46.2, and 46.3, for example by a laser welding process. It is further thinkable that for safety and reliability reasons the contact element 46 may comprise a double welding connection location. That is, the assembling process of the FPC 40 will lead to a pair of welded contacts 60 at each battery unit 11, 12, and 13.

Each IC 50.1, 50.2 and 50.3 is further electrically connected via the contact element 46.1, 46.2 and 46.3 to the respective positive terminal 11.1a, 12.1a and 13.1a of the corresponding one battery cell 11.1, 12.1 and 13.1. According to the embodiment shown in Fig. 1, the case cover 11.1c, 12.1c and 13.1c of the cell case of the one battery cell 11.1, 12.1 and 13.1 is electrically connected to the positive terminal 11.1a, 12.1a and 13.1a, but is electrically isolated from the negative terminal 11.1b, 12.1b and 13.1b thereof. An electrical connection of the first case cover 11.1c with the first positive terminal 11.1a is depicted by means of a first ring 11.1r. Similarly, an electrical connection of the second case cover 12.1c with the second positive terminal 12.1a is depicted by means of a second ring 12.1r and an electrical connection of the third case cover 13.1c with the third positive terminal 13.1a is depicted by means of a third ring 13.1r. The electrical connection of the respective case cover 11.1c, 12.1c and 13.1c with the respective positive terminal 11.1a, 12.1a and 13.1a can be established mechanically by means of a metal junction or connection.

The negative terminal 12.1b of the battery cell 12.1 is electrically connected to the positive terminal 11.1a of the adjacent battery cell 11.1 via the busbar 26.1. Similarly, the negative terminal 13.1b of the battery cell 13.1 is electrically connected to the positive terminal 12.1a of the adjacent battery cell 12.1 via the busbar 26.2, etc., i.e. the battery cells 11.1, 12.1 and 13.1, are connected in series. For example, assuming the resistance of the busbar 26.1 to be negligible, the potential of the second negative terminal 12.1b can be the same magnitude as the potential of the first positive terminal 11.1a. Similarly, the third negative terminal 13.1b of the third battery cell 13.1 is electrically connected to the second positive terminal 12.1a of the second battery cell 12.1 by means of the busbar 26.2. In other words, assuming the resistance of the busbar 26.2 to be negligible, the potential of the third negative terminal 13.1b can be the same magnitude as the potential of the second positive terminal 12.1a. The same explanation can be given in view of the other battery cells in a similar manner.

The power supply terminals of the respective ICs 50.1, 50.2 and 50.3 may be connected to the positive terminals 11.1a, 12.1a, and 13.1a of the respective battery cells 11.1, 12.1 and 13.1 via the respective contact elements 46.1, 46.2 and 46.3. Furthermore, a power supply system of the ICs 50.1, 50.2 and 50.3 may be in a floating state when viewed from the ground potential, denoted by G, which can be the first negative terminal 11.1b of the first battery cell 11.1 or the lowest battery cell 11.1. The battery system 10 comprises a battery management system, BMS 30 that regulates the control of the battery system 10, wherein at least one end of the FPC 40 is electrically connected to the BMS 30. The BMS 30 may be also in ground potential G.

For example, considering the first battery unit 11, the contact element 46.1 enables the wire structure of the FPC 40 to come into contact with the first case cover 11.1c of the one battery cell 11.1. The first case cover 11.1c is in electrical contact with the first positive terminal 11.1a, whereas the first positive terminal 11.1a is also electrically connected to the second negative terminal 12.1b of the second battery cell 12.1 of the second battery unit 12 via the busbar 26.1. The first negative terminal 11.1b is in the ground potential G. A positive terminal, denoted by + symbol, of the first IC 50.1 is electrically connected to the first positive terminal 11.1a via the first contact element 46.1. Hence, the first IC 50.1 is able to measure the potential of the first positive terminal 11.1a of the first battery cell 12.1. A negative terminal, denoted by - symbol, of the first IC 50.1 is electrically connected to the BMS 30, which is at the ground potential G, via the wiring structure. Moreover, the negative terminal of the first IC 50.1 is also in the ground potential G. The wire structure of the FPC 40 between the first IC 50.1 and the end of the FPC 40, near which the first IC 50.1 is disposed on the FPC 40, is electrically connected to the BMS 30. Hence, the first IC 50.1 is able to measure the potential of the first positive terminal 11.1a of the first battery cell 11.1 via the first contact element 46.1.

Furthermore, considering the second battery unit 12, the contact element 46.2 enables the wire structure of the FPC 40 to come into contact with the second case cover 12.1c. The second case cover 12.1c is in electrical contact with the second positive terminal 12.1a, whereas the second positive terminal 12.1a is also electrically connected to third negative terminal 13.1b of the third battery cell 13.1 of the third battery unit 13 via the busbar 26.2. A positive terminal, denoted by + symbol, of the second IC 50.2 is electrically connected to the second positive terminal 12.1a via the second contact element 46.2. Hence, the second IC 50.2 is able to measure the potential of the second positive terminal 12.1a of the second battery cell 12.1. A negative terminal, denoted by - symbol, of the second IC 50.2 is electrically connected to the positive terminal of the first IC 50.1. In other words, the second negative terminal 12.1b is electrically connected to the first positive terminal 11.1a via the busbar 26.1, whereas the first positive terminal 11.1a is electrically connected to the positive terminal of the first IC 50.1 via the first contact element 46.1, and the negative terminal of the second IC 50.2 is electrically connected to the positive terminal of the first IC 50.1. Hence, the second IC 50.2 is able to measure the potential of the second negative terminal 12.1b of the second battery cell 12.1.

Furthermore, a negative terminal, denoted by - symbol, of the third IC 50.3 is electrically connected to the positive terminal of the second IC 50.2, whereas a positive terminal, denoted by + symbol, of the third IC 50.3 is electrically connected to the third positive terminal 13.1a via the third contact element 46.3. Hence, in manner similar to the second IC 50.2, the third IC 50.3 is able to measure the potential of the third positive terminal 13.1a and the third negative terminal 13.1b of the third battery cell 13.1, respectively. The same explanation can be given in view of the other battery units in the battery system 10 that are electrically connected by means of busbars and whose corresponding ICs are electrically connected to each of the neighboring battery units in a similar manner.

Each IC 50.1, 50.2 and 50.3 may include one circuit for measuring the voltage itself and another circuit for detecting the temperature of the corresponding battery unit 11, 12 and 13 thereof. Thus, the ICs 50.1, 50.2 and 50.3 can be configured by a technique that does not require high voltage operation even in the battery system 10 that measures high voltage. Further, since signals are exchanged only between adjacent voltage / temperature detection ICs 50.1, 50.2 and 50.3, the entire wiring becomes simple.

Each IC 50.1, 50.2 and 50.3 is configured to measure the voltage and temperature of each corresponding battery cells 11.1, 12.1 and 13.1, and to send signals comprising information of the measured voltage and temperature to the BMS 30 via the wiring structure. It can be understood that each IC 50.1, 50.2 and 50.3 is configured to send a data signal to the BMS 30 via the wiring structure, wherein the data signal may comprise the positional information of the respective battery cell 11.1, 12.1 and 13.1 of the respective battery unit 11, 12 and 13, an identification number of the one battery cell 11.1, 12.1 and 13.1 of the respective battery unit 11, 12 and 13, voltage and temperature of the one battery cell 11.1, 12.1 and 13.1 of the respective battery unit 11, 12 and 13, along with the time of measurement of the voltage and temperature of the one battery cell 11.1, 12.1 and 13.1 of the respective battery unit 11, 12 and 13. The data signal corresponding to a particular IC 50.1, 50.2 and 50.3 can be stored in a storage unit 32 of the BMS 30 and the data signals of each of the ICs 50.1, 50.2 and 50.3 can be processed by a controller 34 of the BMS 30, to determine the status of each battery unit 11, 12 and 13 of the battery system 10 and that of the battery system 10 as a whole.

Furthermore, the FPC 40 is adapted as a tape on reel with a predefined pitch depending on the width of the battery cell 11.1, 12.1 and 13.1. In other words, the breadth of the FPC 40 may lie with a predefined width corresponding to the width of the wiring structure and the width corresponding to a distance between the respective terminals of the battery cells 11.1, 12.1 and 13.1.

Furthermore, the IC 50.1, 50.2 and 50.3 is configured to detect a voltage drop caused by a resistance of the busbar 26.1, 26.2 and 26.3. In other words, a voltage drop caused due to an internal resistance of the busbars 26.1, 26.2 and 26.3 can be detected by the respective ICs 50.1, 50.2 and 50.3, as the ICs 50.1, 50.2 and 50.3 can measure the current or voltage value between loaded and unloaded conditions. Hence, a difference in the current or voltage can be measured which would enable to measure the resistance of the respective busbar 26.1, 26.2 and 26.3. Furthermore, it is thinkable that the BMS 30 and/or the ICs 50.1, 50.2 and 50.3 can use a correction function to calculate the corrected potential of the negative terminal 11.1b, 12.1b and 13.1b from the measured value obtained from the positive terminal 11.1a, 12.1a and 13.1a of the corresponding neighboring battery cells 11.1, 12.1 and 13.1, as the negative terminal 11.1b, 12.1b and 13.1b of a given battery cell 11.1, 12.1 and 13.1 is electrically connected to the positive terminal 11.1a, 12.1a and 13.1a of the corresponding neighboring battery cell 11.1, 12.1 and 13.1 by means of the busbar 26.1, 26.2 and 26.3.

A communication between the ICs 50.1, 50.2 and 50.3 is realized by a daisy-chain communication. This is of advantage, because no additional printed board circuit is needed, as communication is provided by a two wire daisy-chain within the FPC 40. The battery units 11, 12 and 13, each comprising the respective one battery cell 11.1, 12.1 and 13.1, are electrically connected in series and the corresponding ICs 50.1, 50.2 and 50.3 are arranged along the FPC 40, wherein a positive terminal of one of the ICs 50.1, 50.2 and 50.3 is electrically connected to the cell case of the one battery cell 11.1, 12.1 and 13.1 of the corresponding battery unit 11, 12 and 13, and a negative terminal of said IC 50.1, 50.2 and 50.3 is electrically connected to the cell case of the one battery cell 11.1, 12.1 and 13.1 of the neighboring battery unit 11, 12 and 13 having a lower voltage than that of the corresponding battery unit 11, 12 and 13. Furthermore, each IC 50.1, 50.2 and 50.3 comprises two first bidirectional communication ports connected to the one battery cell 11.1, 12.1 and 13.1 of a first neighboring battery unit 11, 12 and 13 and two second bidirectional communication ports connected to the one battery cell 11.1, 12.1 and 13.1 of a second neighboring battery unit 11, 12 and 13.

A standard or low voltage chip process can be used instead of high voltage (e.g., voltage greater than 10 Volts) which decreases costs on chip level. In other words, by a supply voltage of 5 volts, a communication from one battery unit 11, 12 and 13 to the other battery unit 11, 12 and 13 is done by means of a capacitive isolation, that is an input and output of the battery units 11, 12 and 13 cannot be more than a magnitude of 5 volts (plus and minus 5 volts) with respect to ground potential.

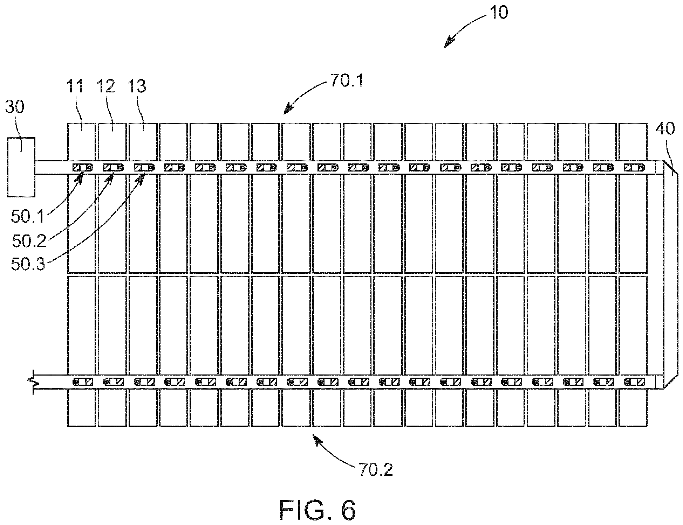

For illustration, Fig. 6 shows a top view onto a battery system 10 with the above described flexible printed circuit 40 according to an embodiment. The battery system 10 comprises a first battery module 70.1 and second battery module 70.2. Each battery module 70.1 and 70.2 includes a plurality of battery units, for example battery units 11, 12 and 13. The FPC 40 comprises a plurality of ICs, for example ICs 50.1, 50.2, and 50.2, which are connected to the battery units 11, 12 and 13 as described above. The FPC 40 enables the battery system 10 to be modular, where the length and the amount of battery units within the battery modules 70.1 and 70.2 can be easily varied. Furthermore, a high reliability can be achieved, as the FPC 40 production process can be run under clean room conditions. In addition, a rework process is simplified since the FPC 40 may be easily removed and replaced in case of defects or when battery units need to be replaced.

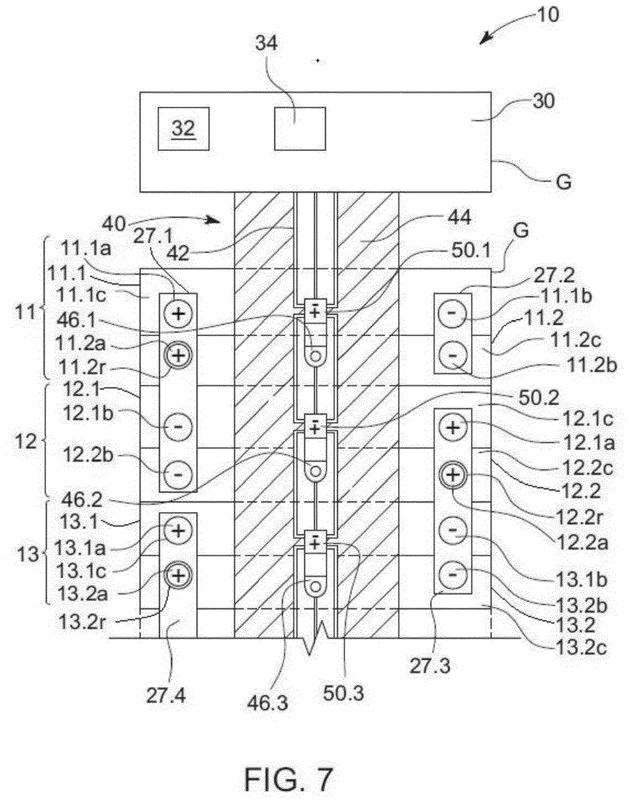

Fig. 7 depicts a top view on a part of a battery system according to a second embodiment. The battery system 10 is a 2P battery system and includes serial connection of battery units including subunits of battery cells being connected in parallel. In detail, the battery system 10 comprises a plurality of battery units 11, 12 and 13, wherein each battery unit 11, 12 and 13 comprises two battery cells 11.1, 11.2, 12.1, 12.2, 13.1 and 13.2 respectively. Each of the battery cells 11.1, 11.2, 12.1, 12.2, 13.1 and 13.2 comprises a respective positive terminal 11.1a, 11.2a, 12.1a, 12.2a, 13.1a and 13.2a, and a respective negative terminal 11.1b, 11.2b, 12.1b, 12.2b, 13.1b and 13.2b.

The first battery unit 11 comprises two battery cells 11.1 and 11.2, namely a first battery unit 11.1 and a second battery unit 11.2, which are electrically connected in a parallel connection to one another by means of a busbar 27.1 connecting the respective positive terminals 11.1a and 11.2a and a busbar 27.2 connecting the respective negative terminals 11.1b and 11.2b of the respective battery cells 11.1 and 11.2 within the first battery unit 11. The second battery unit 12 comprises two battery cells 12.1 and 12.2, namely a first battery cell 12.1 and a second battery cell 12.2, which are electrically connected in a parallel connection to one another by means of the busbar 27.1 connecting the respective negative terminals 12.1b and 12.2b and a busbar 27.3 connecting the respective positive terminals 12.1a and 12.2a of the respective battery cells 12.1 and 12.2 within the second battery unit 12. The third battery unit 13 comprises two battery cells 13.1 and 13.2, namely a first battery cell 13.1 and a second battery cell 13.2, which are electrically connected in a parallel connection to one another by means of a busbar 27.4 connecting the respective positive terminals 13.1a and 13.2a and the busbar 27.3 connecting the respective negative terminals 13.1b and 13.2b of the respective battery cells 13.1 and 13.2 within the battery unit 13. The magnitude of voltages of each of the battery cells 11.1 and 11.2 which are electrically connected in parallel to one another may be similar. Hence, the overall voltage of the first battery unit 11 may be the same as one of the battery cells 11.1 and 11.2. The negative terminal 11.1b of the first battery cell 11.1 is in ground potential G. As the negative the first battery cell 11.1 and the second battery cell 11.2 are in a parallel connection, the negative terminal 11.2b may also be in the ground potential G, corresponding to the negative terminal 11.1b. The voltage of the battery unit 11 corresponds to the voltage of one of the battery cells 11.1 and 11.2. Similarly, it is to be understood the voltages of the respective battery units 12 and 13 correspond to that of their respective battery cells 12.1, 12.2 and 13.1, 13.2.

The battery system 10 comprises an FPC 40 including a plurality of integrated circuits ICs 50.1, 50.2 and 50.3 configured for voltage measurement and temperature measurement, wherein the ICs 50.1, 50.2 and 50.3 being interconnected by a wiring structure of the FPC 40.

In the 2P battery system 10 of the illustrated embodiment, the number of IC 50.1, 50.2 and 50.3 corresponds to the number of battery units 11, 12 and 13. Each IC 50.1, 50.2 and 50.3 is thermally connected to one battery cell 11.2, 12.2, and 13.2 among the respective two battery cells 11.1, 11.2, 12.1, 12.2, 13.1 and 13.2 of said battery unit 11, 12 and 13 via a contact element 46.1, 46.2 and 46.3 being disposed in the FPC 40.

In other words, the first IC 50.1 is electrically connected to a case cover 11.2c of the cell case of the battery cell 11.2 of the first battery unit 11 in order to measure the temperature of the battery cell 11.2. Similarly, the second IC 50.2 is electrically connected to a case cover 12.2c of the cell case of the battery cell 12.2 of the second battery unit 12 in order to measure the temperature of the battery cell 12.2, and the third IC 50.3 is electrically connected to a case cover 13.2c of the cell case of the battery unit 13.2 of the second battery unit 13 in order to measure the temperature of the battery cell 13.2.

Furthermore, said IC 50.1, 50.2, 50.3 is further electrically connected via the contact element 46.1, 46.2 and 46.3 to the respective positive terminal 11.2a, 12.2a and 13.2a of the corresponding battery cell 11.2, 12.2 and 13.2. For example, the case cover 11.2c of the case of the battery cell 11.2 is electrically connected to the positive terminal 11.2a, and is electrically isolated from the negative terminal 11.2b. An electrical connection of the case cover with the positive terminal 11.2a is depicted by means of a ring 11.2r. The electrical connection of the case cover 11.2c with the respective positive terminal 11.2a can be established mechanically by means of a metal junction or connection.

Similarly, the case cover 12.2c of the case of the battery cell 12.2 is electrically connected to the positive terminal 12.2a and is electrically isolated from the negative terminal 12.2b. An electrical connection of the case cover with the positive terminal 12.2a is depicted by means of a ring 12.2r. The electrical connection of the case cover 12.2c with the respective positive terminal 12.2a can be established mechanically by means of a metal junction or connection. The case cover 13.2c of the case of the battery cell 13.2 is electrically connected to the positive terminal 13.2a and is electrically isolated from the negative terminal 13.2b. An electrical connection of the case with the positive terminal 13.2a is depicted by means of a ring 13.2r. The electrical connection of the case cover 13.2c with the respective positive terminal 13.2a can be established mechanically by means of a metal junction or connection.

The negative terminals 12.1b and 12.2b of the respective battery cells 12.1 and 12.2 of the second battery unit 12 are electrically connected to the positive terminal 11.1a and 11.2a of the adjacent battery cells 11.1 and 11.2 of the first battery unit 11 via the busbar 27.1. Similarly, the negative terminals 13.1b and 13.2b of the respective battery cells 13.1 and 13.2 of the third battery unit 13 are electrically connected to the positive terminal 12.1a and 12.2a of the adjacent battery cells 12.1 and 12.2 of the second battery unit 12 via the busbar 27.3. This enables the first battery unit 11, comprising the two battery cells 11.1 and 11.2 which are connected in parallel to one another, the second battery unit 12, comprising the two battery cells 12.1 and 12.2 which are connected in parallel to one another, the third battery unit 13, comprising the two battery cells 13.1 and 13.2 which are connected in parallel to one another, to be connected in series via the busbars 27.1 and 27.2. Hence, the battery units 11, 12 and 13 are electrically connected in series.

According to embodiment of the battery system 10 shown in Fig. 7, with respect to the first battery unit 11, the IC 50.1 is thermally and electrically connected to the case cover 11.2c of the battery cell 11.2. No further IC is thermally connected to the cell case of the battery cell 11.1 and the cell case is electrically isolated from the positive terminal 11.2a and the negative terminal 12.2b. In other words, one IC 50.1 corresponds to the first battery unit 11, wherein the IC 50.1 is thermally and electrically connected to the case cover 11.2c of the battery cell 11.2. The IC 50.1 enables to measure the temperature and voltage of the battery cell 11.2. However, since the battery cells 11.1 and 11.2 are electrically connected in parallel, the battery cell 11.2 may have the same voltage as that of the battery cell 11.1. Moreover, the voltage of the battery unit 11 corresponds to the voltage of one of the battery cells 11.1 and 11.2. Similarly, the IC 50.2 may be able to measure the temperature of the battery cell 12.2 and measure the voltage of the battery cells 12.1 and 12.2, whereas the IC 50.3 may be able to measure the temperature of the battery cell 13.2 and measure the voltage of the battery cells 13.1 and 13.2.

For further understanding of the measurement of temperature of the battery cells 11.2, 12.2 and 13.2 of the battery units 11, 12 and 13 of the 2P battery system 10, and the measurement of voltage of the battery cells 11.1, 11.2, 12.1, 12.2, 13.1 and 13.2 as well as the voltage of the battery units 11, 12 and 13, the aforementioned description in view of Figs. 1 to 6 are to be referred.

The embodiment of the battery system 10 as 2P battery system may be further extended to a 4P battery system, wherein in a 4P battery system, each battery unit comprises four battery units respectively, wherein one IC would be connected to one of the four battery cells of the respective battery unit. The battery units of the 4P battery system are electrically connected in series. Similarly, the battery system 10 can be extended to a 3P, 5P battery system or a battery system in which each battery unit comprises a predetermined number of battery units, wherein each of the battery units are electrically connected in series.

## Claims

1. A battery system (10) comprising:
(i) a plurality of battery units (11, 12, 13), wherein each battery unit (11, 12, 13) comprises at least one battery cell (11.1, 11.2, 12.1, 12.2, 13.1, 13.2), each battery cell including a positive terminal (11.1a, 12.1a, 13.1a), a negative terminal (11.1b, 12.1b, 13.1b) and a cell case; and
(ii) a flexible printed circuit FPC (40) comprising a plurality of integrated circuits ICs (50.1, 50.2, 50.3) configured for voltage measurement and temperature measurement, wherein the ICs (50.1, 50.2, 50.3) are interconnected by a wiring structure of the FPC (40),
wherein each IC (50.1, 50.2, 50.3) is thermally connected to the cell case of one of the battery cells (11.1, 11.2, 12.1, 12.2, 13.1, 13.2) of each battery unit (11, 12, 13) via a contact element (46.1, 46.2, 46.3) being disposed in the FPC (40) and said IC (50.1, 50.2, 50.3) is further electrically connected via the contact element (46.1, 46.2, 46.3) to the respective positive terminal (11.1a, 12.1a, 13.1a) of the one battery cell (11.1, 11.2, 12.1, 12.2, 13.1, 13.2).

2. The battery system (10) according to claim 1, wherein the IC (50.1, 50.2, 50.3) comprises a die (52) with interface bumps (56) on a side of the die (52) facing the FPC (40), wherein the die (52) is electrically connected to the FPC (40) via the interface bumps (56).

3. The battery system (10) according to claim 2, wherein the die (52) is integrated to the FPC (40) by means of a connecting material (58).

4. The battery system (10) according to any one of the preceding claims, wherein a number of ICs (50) of the FPC (40) corresponds to a number of battery units (11, 12, 13) such that one IC (50.1, 50.2, 50.3) corresponds to one battery unit (11, 12, 13).

5. The battery system (10) according to any one of the preceding claims, wherein the contact element (46.1, 46.2, 46.3) comprises at least one welded contact (60) between the FPC (40) and the cell case (11.1c, 12.1c, 13.1c) of the one battery cell (11.1, 11.2, 12.1) of the corresponding battery unit (11, 12, 13).

6. The battery system (10) according to any one of the preceding claims, wherein a case cover (11.1c, 12.1c, 13.1c) of the cell case of the one battery cell (11.1, 11.2, 12.1) of the corresponding battery unit (11, 12, 13) is electrically connected to the positive terminal (11.1a, 12.1a, 13.1a) of the one battery cell (11.1, 11.2, 12.1) and is electrically isolated from the negative terminal (11.1b, 12.1b, 13.1b) of the one battery cell (11.1, 11.2, 12.1).

7. The battery system (10) according to any one of the preceding claims, wherein the negative terminal (11.1b, 12.1b, 13.1b) of the one battery cell (11.1, 11.2, 12.1) of the corresponding battery unit (11, 12, 13) is electrically connected to the positive terminal (11.1a, 12.1a, 13.1a) of the one battery cell (11.1, 12.1, 13.1) of an adjacent battery unit (11, 12, 13) via a busbar (26.1, 26.2, 27.1, 27.2).

8. The battery system (10) according to claim 7, wherein the IC (50.1, 50.2, 50.3) is configured to detect a voltage drop caused by a resistance of the busbar (26.1, 26.2, 27.1, 27.2).

9. The battery system (10) according to any one of the preceding claims, wherein a communication between the ICs (50.1, 50.2, 50.3) is realized by a daisy-chain communication.

10. The battery system (10) according to any one of the preceding claims, wherein a positive terminal of the IC (50.1, 50.2, 50.3) is electrically connected to the cell case of the one battery cell (11.1, 12.1, 13.1) of the corresponding battery unit (11, 12, 13) and a negative terminal of said IC (50.1, 50.2, 50.3) is electrically connected to the cell case of the one battery cell (11.1, 12.1, 13.1) of a neighboring battery unit (11, 12, 13) having a lower voltage than that of the corresponding battery unit (11, 12, 13).

11. The battery system (10) according to any one of the preceding claims, wherein each IC (50.1, 50.2, 50.3) comprises two first bidirectional communication ports connected to the one battery cell (11.1, 12.1, 13.1) of a first neighboring battery unit (11, 12, 13) and two second bidirectional communication ports connected to the one battery cell (11.1, 12.1, 13.1) of a second neighboring battery unit (11, 12, 13).

12. The battery system (10) according to any one of the preceding claims, wherein the FPC (40) is a tape on reel with a predefined pitch of the ICs (50.1, 50.2, 50.3) depending on the width of the battery units (11, 12, 13).

13. The battery system (10) according to any one of the preceding claims, wherein the battery system (10) comprises a battery management system BMS (30), wherein at least one end of the FPC (40) is electrically connected to the BMS (30).

14. A battery electric vehicles including a battery system (10) according to any one of the claims 1 to 13.

## Patentansprüche

1. Batteriesystem (10), das Folgendes umfasst:
(i) eine Vielzahl von Batterieeinheiten (11, 12, 13), wobei jede Batterieeinheit (11, 12, 13) mindestens eine Batteriezelle (11.1, 11.2, 12.1, 12.2, 13.1, 13.2) umfasst, wobei jede Batteriezelle einen positiven Anschluss (11.1a, 12.1a, 13.1a), einen negativen Anschluss (11.1b, 12.1b, 13.1b) und ein Zellengehäuse aufweist; und
(ii) eine flexible Leiterplatte FPC (40), die eine Vielzahl von integrierten Schaltungen ICs (50.1, 50.2, 50.3) umfasst, die zur Spannungsmessung und Temperaturmessung konfiguriert sind, wobei die ICs (50.1, 50.2, 50.3) durch eine Verdrahtungsstruktur der FPC (40) miteinander verbunden sind,
wobei jede IC (50.1, 50.2, 50.3) mit dem Zellengehäuse einer der Batteriezellen (11.1, 11.2, 12.1, 12.2, 13.1, 13.2) jeder Batterieeinheit (11, 12, 13) über ein Kontaktelement (46.1, 46.2, 46.3), das in der FPC (40) angeordnet ist, thermisch verbunden ist und die besagte IC (50.1, 50.2, 50.3) ferner über das Kontaktelement (46.1, 46.2, 46.3) mit dem jeweiligen positiven Anschluss (11.1a, 12.1a, 13.1a) der einen Batteriezelle (11.1, 11.2, 12.1, 12.2, 13.1, 13.2) elektrisch verbunden ist.

2. Batteriesystem (10) nach Anspruch 1, wobei die IC (50.1, 50.2, 50.3) einen Chip (52) mit Schnittstellenhöckern (56) auf einer der FPC (40) zugewandten Seite des Chips (52) umfasst, wobei der Chip (52) über die Schnittstellenhöcker (56) elektrisch mit der FPC (40) verbunden ist.

3. Batteriesystem (10) nach Anspruch 2, wobei der Chip (52) mittels eines Verbindungsmaterials (58) in die FPC (40) integriert ist.

4. Batteriesystem (10) nach einem der vorhergehenden Ansprüche, wobei eine Anzahl von ICs (50) der FPC (40) einer Anzahl von Batterieeinheiten (11, 12, 13) entspricht, so dass eine IC (50.1, 50.2, 50.3) einer Batterieeinheit (11, 12, 13) entspricht.

5. Batteriesystem (10) nach einem der vorhergehenden Ansprüche, wobei das Kontaktelement (46.1, 46.2, 46.3) mindestens einen geschweißten Kontakt (60) zwischen der FPC (40) und dem Zellengehäuse (11.1c, 12.1c, 13.1c) der einen Batteriezelle (11.1, 11.2, 12.1) der entsprechenden Batterieeinheit (11, 12, 13) aufweist.

6. Batteriesystem (10) nach einem der vorhergehenden Ansprüche, wobei eine Gehäuseabdeckung (11.1c, 12.1c, 13.1c) des Zellengehäuses der einen Batteriezelle (11.1, 11.2, 12.1) der entsprechenden Batterieeinheit (11, 12, 13) elektrisch mit dem positiven Anschluss (11.1a, 12.1a, 13.1a) der einen Batteriezelle (11.1, 11.2, 12.1) verbunden und vom negativen Anschluss (11.1b, 12.1b, 13.1b) der einen Batteriezelle (11.1, 11.2, 12.1) elektrisch isoliert ist.

7. Batteriesystem (10) nach einem der vorhergehenden Ansprüche, wobei der negative Anschluss (11.1b, 12.1b, 13.1b) der einen Batteriezelle (11.1, 11.2, 12.1) der entsprechenden Batterieeinheit (11, 12, 13) mit dem positiven Anschluss (11.1a, 12.1a, 13.1a) der einen Batteriezelle (11.1, 12.1, 13.1) einer benachbarten Batterieeinheit (11, 12, 13) über eine Sammelschiene (26.1, 26.2, 27.1, 27.2 ) elektrisch verbunden ist.

8. Batteriesystem (10) nach Anspruch 7, wobei die IC (50.1, 50.2, 50.3) so konfiguriert ist, dass sie einen durch einen Widerstand der Sammelschiene (26.1, 26.2, 27.1, 27.2) verursachten Spannungsabfall erkennt.

9. Batteriesystem (10) nach einem der vorhergehenden Ansprüche, wobei eine Kommunikation zwischen den ICs (50.1, 50.2, 50.3) durch eine Daisy-Chain-Kommunikation realisiert ist.

10. Batteriesystem (10) nach einem der vorhergehenden Ansprüche, wobei ein positiver Anschluss der IC (50.1, 50.2, 50.3) elektrisch mit dem Zellengehäuse der einen Batteriezelle (11.1, 12.1, 13.1) der entsprechenden Batterieeinheit (11, 12, 13) verbunden ist und ein negativer Anschluss der IC (50.1, 50.2, 50.3) elektrisch mit dem Zellengehäuse der einen Batteriezelle (11.1, 12.1, 13.1) einer benachbarten Batterieeinheit (11, 12, 13) verbunden ist, die eine niedrigere Spannung als die der entsprechenden Batterieeinheit (11, 12, 13) aufweist.

11. Batteriesystem (10) nach einem der vorhergehenden Ansprüche, wobei jede IC (50.1, 50.2, 50.3) zwei erste bidirektionale Kommunikationsports, die mit der einen Batteriezelle (11.1, 12.1, 13.1) einer ersten benachbarten Batterieeinheit (11, 12, 13) verbunden sind, und zwei zweite bidirektionale Kommunikationsports, die mit der einen Batteriezelle (11.1, 12.1, 13.1) einer zweiten benachbarten Batterieeinheit (11, 12, 13) verbunden sind, umfasst.

12. Batteriesystem (10) nach einem der vorhergehenden Ansprüche, wobei die FPC (40) ein Tape-on-Reel mit einem vordefinierten Abstand der ICs (50.1, 50.2, 50.3) in Abhängigkeit von der Breite der Batterieeinheiten (11, 12, 13) ist.

13. Batteriesystem (10) nach einem der vorhergehenden Ansprüche, wobei das Batteriesystem (10) ein Batteriemanagementsystem BMS (30) umfasst, wobei mindestens ein Ende der FPC (40) elektrisch mit dem BMS (30) verbunden ist.

14. Batterieelektrische Fahrzeuge mit einem Batteriesystem (10) nach einem der Ansprüche 1 bis 13.

## Revendications

1. Système de batterie (10) comprenant :
(i) une pluralité d'unités de batterie (11, 12, 13), où chaque unité de batterie (11, 12, 13) comprend au moins un élément de batterie (11.1, 11.2, 12.1, 12.2, 13.1, 13.2), chaque élément de batterie comportant une borne positive (11.1a, 12.1a, 13.1a), une borne négative (11.1b, 12.1b, 13.1b) et un boîtier d'élément ; et
(ii) un circuit imprimé flexible FPC (40) comprenant une pluralité de circuits intégrés IC (50.1, 50.2, 50.3) configurés pour mesurer la tension et mesurer la température, où les IC (50.1, 50.2, 50.3) sont interconnectés par une structure de câblage du FPC (40),
dans lequel chaque IC (50.1, 50.2, 50.3) est connecté thermiquement au boîtier d'élément de l'un des éléments de batterie (11.1, 11.2, 12.1, 12.2, 13.1, 13.2) de chaque unité de batterie (11, 12, 13) via un élément de contact (46.1, 46.2, 46.3) qui est disposé dans le FPC (40), et ledit IC (50.1, 50.2, 50.3) est en outre connecté électriquement via l'élément de contact (46.1, 46.2, 46.3) à la borne positive (11.1a, 12.1a, 13.1a) respective dudit un élément de batterie (11.1, 11.2, 12.1, 12.2, 13.1, 13.2).

2. Système de batterie (10) selon la revendication 1, dans lequel l'IC (50.1, 50.2, 50.3) comprend une matrice (52) avec des bosses d'interface (56) sur un côté de la matrice (52) faisant face au FPC (40), dans lequel la matrice (52) est connectée électriquement au FPC (40) via les bosses d'interface (56).

3. Système de batterie (10) selon la revendication 2, dans lequel la matrice (52) est intégrée au FPC (40) au moyen d'un matériau de connexion (58).

4. Système de batterie (10) selon l'une quelconque des revendications précédentes, dans lequel un nombre des IC (50) du FPC (40) correspond à un nombre des unités de batterie (11, 12, 13) de sorte qu'un IC (50.1, 50.2, 50.3) correspond à une unité de batterie (11, 12, 13).

5. Système de batterie (10) selon l'une quelconque des revendications précédentes, dans lequel l'élément de contact (46.1, 46.2, 46.3) comprend au moins un contact soudé (60) entre le FPC (40) et le boîtier d'élément (11.1c, 12.1c, 13.1c) dudit un élément de batterie (11.1, 11.2, 12.1) de l'unité de batterie (11, 12, 13) correspondante.

6. Système de batterie (10) selon l'une quelconque des revendications précédentes, dans lequel un couvercle de boîtier (11.1c, 12.1c, 13.1c) du boîtier d'élément dudit un élément de batterie (11.1, 11.2, 12.1) de l'unité de batterie (11, 12, 13) correspondante est connecté électriquement à la borne positive (11.1a, 12.1a, 13.1a) dudit un élément de batterie (11.1, 11.2, 12.1) et est isolé électriquement de la borne négative (11.1b, 12.1b, 13.1b) dudit un élément de batterie (11.1, 11.2, 12.1).

7. Système de batterie (10) selon l'une quelconque des revendications précédentes, dans lequel la borne négative (11.1b, 12.1b, 13.1b) dudit un élément de batterie (11.1, 11.2, 12.1) de l'unité de batterie (11, 12, 13) correspondante est connectée électriquement à la borne positive (11.1a, 12.1a, 13.1a) dudit un élément de batterie (11.1, 12.1, 13.1) d'une unité de batterie (11, 12, 13) adjacente via une barre omnibus (26.1, 26.2, 27.1, 27.2).

8. Système de batterie (10) selon la revendication 7, dans lequel l'IC (50.1, 50.2, 50.3) est configuré pour détecter une chute de tension causée par une résistance de la barre omnibus (26.1, 26.2, 27.1, 27.2).

9. Système de batterie (10) selon l'une quelconque des revendications précédentes, dans lequel une communication entre les IC (50.1, 50.2, 50.3) est réalisée par une communication en chaîne.

10. Système de batterie (10) selon l'une quelconque des revendications précédentes, dans lequel une borne positive de l'IC (50.1, 50.2, 50.3) est connectée électriquement au boîtier d'élément dudit un élément de batterie (11.1, 12.1, 13.1) de l'unité de batterie (11, 12, 13) correspondante, et une borne négative dudit IC (50.1, 50.2, 50.3) est connectée électriquement au boîtier d'élément dudit un élément de batterie (11.1, 12.1, 13.1) d'une unité de batterie (11, 12, 13) voisine ayant une tension inférieure à celle de l'unité de batterie (11, 12, 13) correspondante.

11. Système de batterie (10) selon l'une quelconque des revendications précédentes, dans lequel chaque IC (50.1, 50.2, 50.3) comprend deux premiers ports de communication bidirectionnels connectés audit un élément de batterie (11.1, 12.1, 13.1) d'une première unité de batterie (11, 12, 13) voisine et deux deuxièmes ports de communication bidirectionnels connectés audit un élément de batterie (11.1, 12.1, 13.1) d'une deuxième unité de batterie (11, 12, 13) voisine.

12. Système de batterie (10) selon l'une quelconque des revendications précédentes, dans lequel le FPC (40) est un ruban sur bobine avec un pas prédéfini des IC (50.1, 50.2, 50.3) dépendant de la largeur des unités de batterie (11, 12, 13).

13. Système de batterie (10) selon l'une quelconque des revendications précédentes, le système de batterie (10) comprenant un système de gestion de batterie, BMS, (30), dans lequel au moins une extrémité du FPC (40) est connectée électriquement au BMS (30).

14. Véhicule électrique à batterie comportant un système de batterie (10) selon l'une quelconque des revendications 1 à 13.
